# EUROPEAN PATENT SPECIFICATION

(11) **EP 3 308 459 B1**
(45) Date of publication and mention of the grant of the patent: **24.07.2019**
(21) Application number: 16731676.9
(22) Date of filing: 10.06.2016
(51) Int. Cl.: H02S 20/32, H02S 40/22, H02S 40/44, H01L 31/054

(54) **FLOATING, CONCENTRATING PHOTOVOLTAIC SYSTEM**
SCHWEBENDES KONZENTRIERENDES PHOTOVOLTAIKSYSTEM
SYSTÈME PHOTOVOLTAÏQUE À CONCENTRATION FLOTTANT

(30) Priority: 11.06.2015 NO 20150767
(43) Date of publication of application: 18.04.2018
(73) Proprietor: Svalin Solar AS, 4014 Stavanger (NO)
(72) Inventor: ASLAKSEN, Åge Eivind, 4014 Stavanger (NO)
(74) Representative: Håmsø Patentbyrå AS
(86) International application number: PCT/NO2016/050123
(87) International publication number: WO 2016/200276

(56) References cited:
- EP-A2- 2 075 853
- WO-A1-2012/131543
- DE-A1-102009 038 090
- DE-A1-102011 108 326
- US-A- 4 296 731
- US-A- 4 771 764

## Description

The present invention relates to a floatable module for concentrating incident solar radiation onto photovoltaic elements. More specifically the invention relates to a floatable module comprising a plurality of photovoltaic elements, provided as elongated strips, each having a surface for receiving incident solar radiation, a plurality of reflectors with primary, concave surfaces for concentrating said incident solar radiation onto said photovoltaic elements, said reflectors having length axes substantially parallel to said elongated strips, and a base onto which said reflectors and photovoltaic elements are placed. The invention also relates to a system including one or more such modules as well as a method for installing and operating such a system.

In the photovoltaic industry there is a continuously ongoing aim of lowering the price of produced power. 25 years ago, solar/photovoltaic (PV) cells were still regarded as a niche market and interesting only in off-grid and space applications areas where other sources of power either were unavailable or too expensive. Today, the situation is completely changed. Increased cell performance at reduced production and installation costs have cut down energy pay-back times for solar modules significantly. Still, a necessary road ahead also for PV systems is a further reduction in the price of solar electricity in order to become cost-competitive with other sources of energy. In a recent article in Nature Energy magazine it is concluded that *"the installed cost of solar must fall dramatically to enable 30% penetration by 2050".* Basically, this can be achieved either by cutting production and installation costs without hampering module performance, or by increasing power output without increasing production and installation costs. Preferably both.

In an installed PV system, the cost of photovoltaic (PV) elements (solar cells) today accounts for about one third of the total material costs. This high material cost has been attempted reduced by concentrating the incident solar radiation by means of concentrating reflectors or lenses. In such concentrating photovoltaic systems (CPVs) the allocation of costs in the installed system is shifted from the PV elements towards installation and other system costs due to the reduced need for PV materials and the increased need for the relatively complicated infrastructure required to concentrate the incident solar radiation, including the need for cooling and also potentially tracking the sun's motion in the sky, often in several rotatable axes. Despite the significant improvements achieved in the cost per watt ratio over the last decades, there is still a need to reduce the cost of PV energy.

US 4,771,764 discloses a water-borne two-axes tracking solar energy collecting and converting system employing multiple lens collectors for re-directing sunlight for concentration on photovoltaic cells.

Relevant background technology is also disclosed in the following documents:
- WO 2012/131543 A1;
- DE 10 2009 038090 A1; and
- US 4,296,731 A.

It is an object of the present invention to provide a CPV module and system with low production, installation and maintenance costs.

The invention has for its general object to remedy or to reduce at least one of the drawbacks of the prior art, or at least provide a useful alternative to prior art.

The object is achieved through features, which are specified in the description below and in the claims that follow.

The invention is defined by the independent patent claims. The dependent claims define advantageous embodiments of the invention.

In a first aspect, the invention relates to a floatable module for concentrating incident solar radiation onto photovoltaic elements, the module comprising:
- a plurality of photovoltaic elements, provided as substantially parallel elongated strips, each having a surface for receiving incident solar radiation;
- a plurality of linear reflectors with primary, concave surfaces for concentrating said incident solar radiation onto said photovoltaic elements, said reflectors having horizontal length axes substantially parallel to said elongated strips; and
- a base onto which said reflectors and photovoltaic elements are placed, wherein
- said photovoltaic elements are placed non-horizontally on said base such that a normal of said surface for receiving incident solar radiation has an upwardly directed vertical component.

Most of the incident sunlight will be concentrated and directed downwardly from the concave surface of the reflector and onto the PV element. This implies that the PV element will not be obstructing/shading the incident solar radiation, leading to higher conversion efficiency. At the same time, the non-horizontal orientation of the PV elements prevent dust and other unwanted impurities to accumulate thereon, thus avoiding shading and potential "hot spot" heating, while at the same time reducing maintenance costs. The concave shape of the primary surface allows the incident solar radiation to be substantially evenly concentrated onto the full receiving surface area of the PV element.

The PV elements used in the module may be made from assembled off-the-shelf solar cells, or the PV elements may be assembled from solar cells specifically made or cut for use in the module. The solar cells may be silicon-based solar cells, but other types of solar cells may equally well be used. In certain embodiments, the solar cells may be back-contacted back-junction silicon solar cells or it may be hetero-junction solar cells, as will be understood by a person skilled in the art.

In a preferred embodiment, as will be described more detail below with reference to the accompanying drawings, the reflectors may be provided in rows forming a continuous structure with the PV elements connected thereto. The direction of each row then defines the length axis of the reflectors. In one embodiment, the PV elements may be placed slightly above the lowest point of the continuous reflector structure, i.e. the point nearest water in a position of use, so as to further reduce the risk of impurities, mainly dust, shading the receiving surface of the PV elements.

The base is substantially flat, implying that the reflectors and PV elements are provided substantially horizontally and at equal height. This is in contrast to some CPV systems where the different reflectors and PV elements are provided in complicated racks with different height levels and with tracking around multiple axes. As such, a simple, flat base structure provides a robust and easy installable module in a floating CPV system as will be described below. A flat base also ensures that the PV elements may be provided close to a surface of the base that may be in direct contact with water, which may significantly improve cooling of the PV elements. In a preferred embodiment said base may be provided with an upper surface and a lower surface, and wherein said plurality of photovoltaic elements may be provided in contact with said upper surface of the base, which may be beneficial for cooling the heated PV elements. Another advantage of a substantially flat module is that there is no need to pump water up above the water line in order to provide sufficient cooling for the PV elements, leading to reduced energy consumption while at the same time eliminating the risk of water leakage.

In a preferred embodiment, between said upper and lower surfaces, the base may be provided with ducts extending substantially parallel to said elongated strips of PV elements. The ducts may enable water to flow through the base in parallel with PV elements for improved cooling thereof. In a cross-sectional view, in a plane normal to the length direction of the ducts, the base, between the upper and lower surfaces, may have the appearance of a truss work, which may be beneficial for the flow of cooling water, for leading heat from the PV elements and down into the water reservoir as the truss work will act as a heat sink, and for giving the base improved stability and mechanical strength.

In one embodiment said reflectors may comprise an outer portion including an outer reflecting surface material and an inner portion comprising a stabilizing structure. The outer reflective surface material may typically be a layer of a highly reflective metal, such as aluminium, whereas the inner stabilizing structures may be formed as ribs, a truss work, a honeycomb structure or another light-weight, strong structure. The inner, stabilizing structure may be made from the same material as the reflecting surface or it may be provided in a different material. The stabilizing structure inside the reflectors may also be a filler material with relatively low density but with good mechanical strength. In one embodiment it may be a light-weight synthetic foam material, while in another embodiment it may be balsawood. The inner stabilizing structure, according to any of the embodiments mentioned above, has the advantage of reducing module cost and weight, which may simplify installation without compromising the mechanical strength. It should also be noted that outer portion may be provided as a thin foil of a reflective material provided on top of a profile providing more stability, or the outer portion may include sandwich or laminate structure being supported by said inner stabilizing structure, where the outer layer of such sandwich or laminate structure is the reflective surface.

In one embodiment said plurality of reflectors may further be formed with secondary, convex surfaces for reflecting non-direct and diffuse solar radiation onto said photovoltaic elements. A convex surface will obviously be the backside of a primary concave surface. As the reflectors will typically be provided linearly in consecutive rows, the convex backside of the "next row" will then act as a secondary reflector for diffuse light and other incident light that is not reflected directly from the concave reflector and onto the PV element. A lower portion of the reflectors, defining a transition between the concave surface of one reflector and the convex surface of the next reflector may also act as a secondary reflector.

In a second aspect the invention relates to a system for concentrating incident solar radiation onto photovoltaic elements, the system comprising:
- a floatable module according to the first aspect of the invention;
- a water reservoir with a ground area adapted to house said base; and
- a rotation means for rotating said base in said water reservoir around a substantially vertical axis.

In its simplest form, the system according to the second aspect of the invention may basically be provided as a water reservoir wherein one or more modules according to the first aspect of the invention are rotatably provided. The water reservoir may be a natural reservoir or it may be artificially created. In a preferred embodiment, the water reservoir may be substantially circular, which may maximize the use of area while at the same time allowing rotation of one or more modules in the reservoir. Preferably said one or more modules may also be provided as or assembled to a substantially circular form fitting complementary into the reservoir.

In one embodiment, the rotation means may be provided as a part of the floatable module, which may further simplify installation of the system as the module may be more or less fully self-contained requiring very little additional infrastructure on-site in order to become operative. The rotation means may include a motorized device engaging a wall of or a bottom portion of said water reservoir so as to rotate the module(s) relative to the surrounding walls of the water reservoir. The rotation means may in one embodiment simply be one or more rotating wheels creating rotation by frictional contact between the mentioned walls of the water reservoir and the module(s). Alternatively, the rotation means may be provided externally from the module, typically in the walls of the water reservoir.

In a preferred embodiment, the system may further comprise a tracking means for controlling the rotation of the module such that length axes of said linear reflectors are oriented towards the horizon at a point substantially vertically below the position of the sun in the sky. Tracking may be beneficial for optimizing the performance of the floating CPV system. In the simplest embodiment, tracking may be done by initializing and rotating the module at a predetermined speed based on knowledge about the sun's daily movement in the sky. Alternatively, the system may be provided with an optical sensor tracking the sun's position in the sky and rotating the module thereafter.

In one embodiment the system may comprise a pump for circulating water from the bottom of the water reservoir and up towards the floating module. This may be beneficial for moving cold water up towards the floating base, which may lead to better cooling and thus improved conversion efficiencies for the PV elements. A person skilled in the art knows that conversion efficiencies for PV elements are reduced with increasing temperature. For non-concentration PV concepts, excessive heat is usually not a big problem, and the cost of cooling is usually not justified. In concentrated PV systems, however, excessive heat may become a big problem severely reducing conversion efficiencies if not at least partially remedied by cooling.

In one embodiment the top of said module may be covered by glass, and the module may be water-tightly encapsulated. Glass may protect the modules from the surroundings, and it may also make cleaning of the modules easier as more crude ways of flushing/cleaning may be used which could otherwise potentially damage the module. In one embodiment cleaning may be done by means of washing robots. Another advantage of cleaning a floating PV system, is that water may be recycled. The encapsulation may allow the whole module to be lowered deeper, i.e. to be provided with less buoyancy, into the water so that the PV elements are provided below the water line during use, which may lead to improved cooling.

In one embodiment, the system according to the second aspect of the invention may be combined with a system for hot water production. This may be particularly interesting if the system is provided on a roof top or is connected to a local consumer in any other way. The idea is then that the water that has been heated upon cooling of the module, and in particular for cooling the PV elements, is used as hot water in a household. Water channels/ducts may be connected to the underside of the base, or preferably at the underside of the encapsulation if present. Water is then circulated in these ducts along said PV elements, whereby heat is exchanged between the warm PV elements and the water. The hot water production system may give the PV system a significant added value without limiting the PV conversion efficiency and without increasing the cost of the system in any significant way.

In a third aspect, the invention relates to a method for assembling a system according the second aspect of the invention, the method comprising the steps of:
- providing a water reservoir by putting up a wall, preferably substantially circular, defining a volume with a closed ground area;
- adding a water-tight membrane onto said closed ground area;
- filling at least a portion of the volume defined by the wall with water;
- providing one or more modules according to the first aspect of the invention onto the water in the water reservoir.

The module-based, and potentially self-contained, system makes installation exceptionally easy and little time-consuming. In the simplest version, the module(s) may simply be lifted onto the water in the water reservoir and be more or less ready to use from the beginning. The potential light-weight construction of the reflectors and base may even remove the need for heavy lifting equipment in order to install the modules. The modules may be sized so as to be able to be transported by means of standardized shipping containers.

After assembling the system, the method may also include producing power, and potentially hot water, by means of the assembled system. Preferably the method then also includes the steps of
- tracking the sun's motion in the sky; and
- rotating said one or more modules such that the length axes of said reflectors are oriented towards a point in the horizon substantially vertically below the sun's position in the sky in. order to optimize the power production.

In the following is described an example of a preferred embodiment illustrated in the accompanying drawings, wherein:
- Fig. 1: shows, in a perspective side-view, a module according to the first aspect of the invention;
- Fig. 2: shows, in an enlarged view, a detail from Fig. 1;
- Fig. 3: shows, in a perspective and partly cut-away view, a system according to the second aspect of the invention; and
- Figs. 4-7: show, schematically, a method of assembling a system as shown in Fig. 3.

In the following the reference numeral 1 will denote a module according to the first aspect of the invention, whereas the reference numeral 10 will be used to denote a system comprising one or more such modules 1. Identical reference numerals will be used to indicate identical or similar features in the drawings. The drawings are shown simplified and schematically and the various features in the drawings are not necessarily drawn to scale.

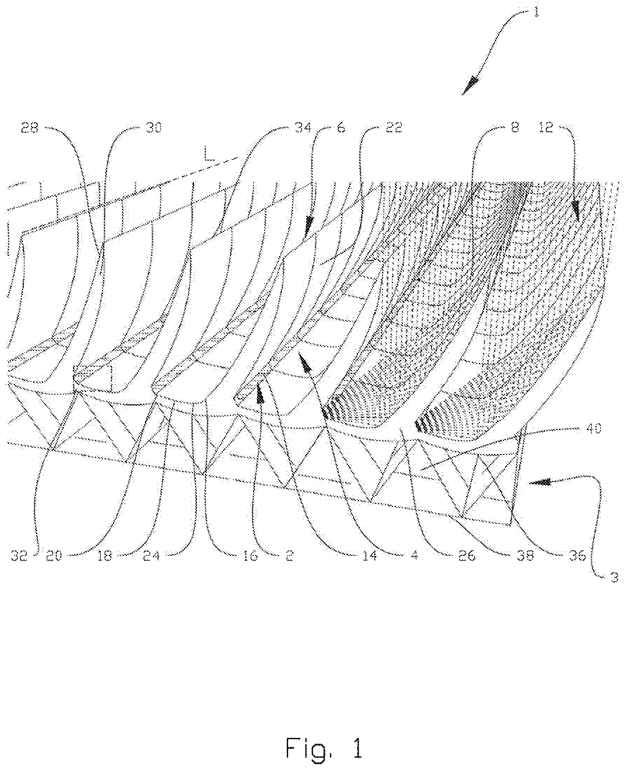

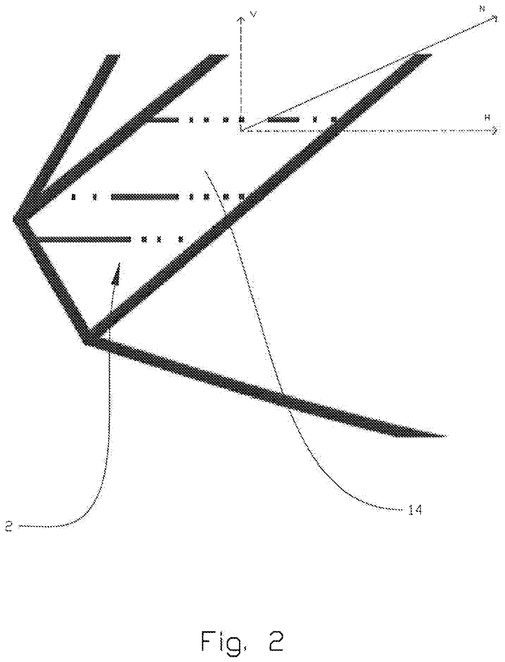

Fig. 1 shows a module 1 according to the present invention. The module 1 comprises a plurality of photovoltaic (PV) cells 2 assembled to form photovoltaic elements 4 in the form of elongated strips. The elongated strips 4 may be made from a series of off-the-shelf PV cells 2 or the PV cells 2 may be produced and/or cut specifically for use in this module 1. Along each strip 4 is provided a linear reflector 6 formed with a primary reflecting, concave surface 8 for concentrating incident solar radiation 12 onto the elongated strips of PV elements 4. Length axes L of the reflectors are defined as running in parallel with the elongated strips 4. The incident solar radiation is indicated by stippled vertically incoming lines in only a part of the drawing for the sake of clarity. After hitting the primary reflective, concave surface 8, the incident solar radiation 12 is directed and concentrated downwardly, opposite of the incident direction, onto the PV elements 4 as indicated in the figure. Due to the concave form of the primary reflecting surface 8, the incident solar radiation 12 is focused substantially evenly onto a receiving surface 14 of the PV elements 4. The PV elements 4 are oriented such that a surface normal (N) of the receiving surface 14 has a normal with an upwardly directed vertical component, as can be best seen in the enlarged view in Fig. 2. This implies both that the PV elements 4 may be located out of the directly incident solar radiation 12, so as to avoid obstruction, and that the problem of accumulation of impurities, such as sand, leaves etc., may be avoided or at least significantly reduced. The side-view appearance of the reflectors 6 may be described as resembling that of a plurality of rows of seats, as on a bus, where the seats are packed closely together and form a more or less continuous structure. Every primary reflective, concave surface 8 has a smoothly curved transition 16 into a substantially horizontal lower portion 18 (the "seat part"), where the PV elements are placed at the distal ends 20 of the lower portions 18. The PV elements 4 mark the transition from the lower portion 18 of one reflector 6 to a secondary reflective, convex surface 22 of the next reflector 6. The secondary reflective, convex surface 22 and the lower portion 18 reflect diffuse light and other non-direct incident solar radiation onto the PV elements 4. By this set up, the distance between the primary reflective, concave surface 8 and the receiving surface 14 of the PV elements is maximized, which is beneficial for obtaining an as normal (perpendicular) reflection as possible from the primary reflective, concave side and onto the receiving surface 14. The placement of the PV elements 4 near the lower portion 18 of the reflector 6 also keeps the PV elements close to the water in a position of use, which is beneficial for cooling as will be described below. At the same time, the PV elements 4 are placed slightly above the lowest point 24 of the lower portion 18, which also reduces the risk of accumulation of impurities thereon. In the shown embodiment, the distance between the rows of reflectors 6 is approximately 10 cm. In other embodiments the distance may be in the range 5 cm to 20 cm, however the invention is not limited to any specific distance between the rows of reflectors 6.

In the shown embodiment, the reflectors 6 are formed with an outer portion 28 comprising a reflective layer of aluminium on the outside and an inner portion 30 with a stabilizing structure on the inside. The stabilizing structure 30 is not shown in detail in the figure, but various embodiments were discussed in the general part of the description above. The inner, stabilizing structure reduces material costs and weight and increases buoyancy of the module 1. In the curved transition 16 between the primary reflective, concave surface 8 and the lower portion 18 the reflectors 6 are formed with a bulge 26/increased width portion which contributes to increased buoyancy, further justifying a thinner construction of the reflectors in an area 32 below the PV elements 4, reducing the distance between the PV elements 4 and water for improved cooling. Near their top ends 34, the reflectors 6 are made slim/pointy in order to reduce shading as much as possible. The pointy top ends 34 are also beneficial from a constructional point of view as the moment acting on the reflectors 6 is reduced towards their top ends 34.

The continuous structure of reflectors 6 and PV elements 4 are placed onto a base 3, to which the reflectors are connected by not shown connection means. The connection means may for instance be one of glue, bolts or screws or a combination thereof. The base 3 is formed with an upper surface 36 and a lower surface 38 with ducts 40 extending in parallel with the PV elements 4 between the upper and lower surfaces 36, 38. As water circulates through the ducts 40, the PV elements 4, which may become very warm from the concentration of sunlight, are cooled. In the shown embodiment, the ducts 40 are formed with triangular-cross sections of giving the base 3, in a side- or cross-section view, the appearance of a truss work. The triangular shapes of the ducts 40 are also beneficial for reinforcing the construction of the base 3.

Fig. 2 shows a detailed view of the area marked with a stippled rectangle in Fig. 1. The figure shows in somewhat more detail the normal N of the receiving surface 14 of the PV elements 4, and its upwardly directed vertical component V. The horizontal component H is also indicated in the figure.

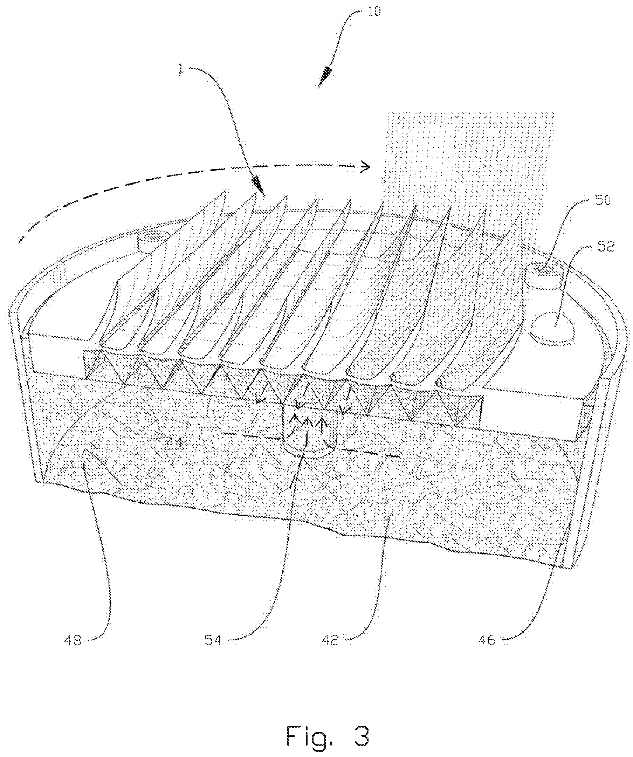

Fig. 3 shows a partially cut away side-view of a system 10 according to the second aspect of the invention. In the shown embodiment, the module 1 is given a substantially circular form to fit complementary into the ground area 42 of a water reservoir 44 the volume of which is defined by a wall 46 and a water tight membrane 48. In an alternative embodiment, as will be indicated schematically with reference to the following figures, the system 10 may comprise a plurality of modules 1 assembled so as to fit into a water reservoir 44 while optimizing the use of its ground area 42. The substantially circular module 1 is rotatably provided in the water reservoir 44. In the shown embodiment rotation means 50 in the form of a plurality wheels, of which one or more may be actively driven, are provided on the module 1 and adapted to engage the inside of the wall 46 so as to create rotation of the module 1 in the water reservoir 44 by means of friction between the inside of the wall 46 and the wheels 50. The module 1 is rotated around a not shown vertical axis in a clock-wise direction as indicated by the curved, stippled arrow. The system is further provided with a tracking means 52, here in the form of an optical sensor adapted to track the sun's motion across the sky. The sensed solar motion is read into a not shown control unit that further controls the rotation such that the length direction L of the linear reflectors 6, as shown in Fig. 1, are always directed towards the horizon at a point substantially vertically below the sun. The system 10 is also shown comprising a pump 54 adapted to circulate water from the bottom of the water reservoir 44 and up towards the base 3. The flow of water, which is indicated with arrows in the figure, will then result mainly from the pump 54 which circulates water through the ducts 40 in the base 3.

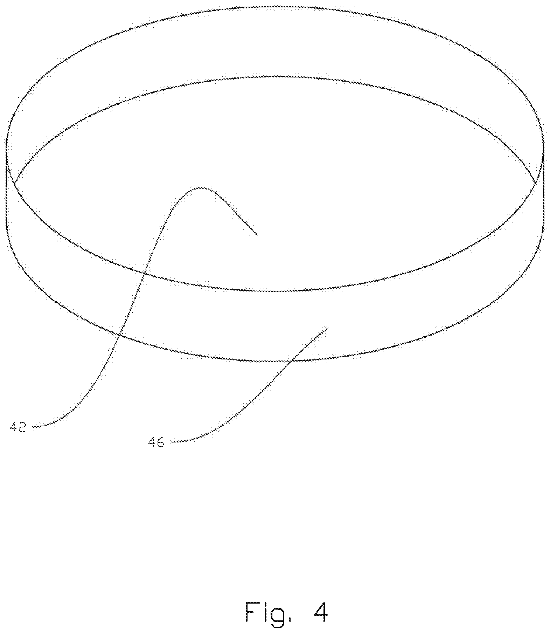

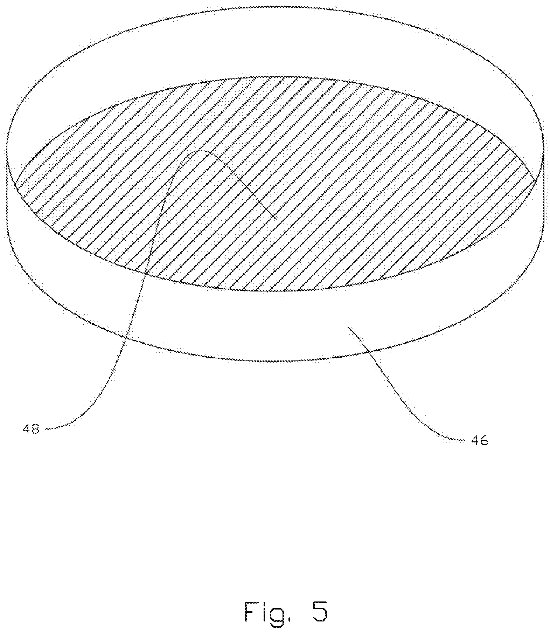

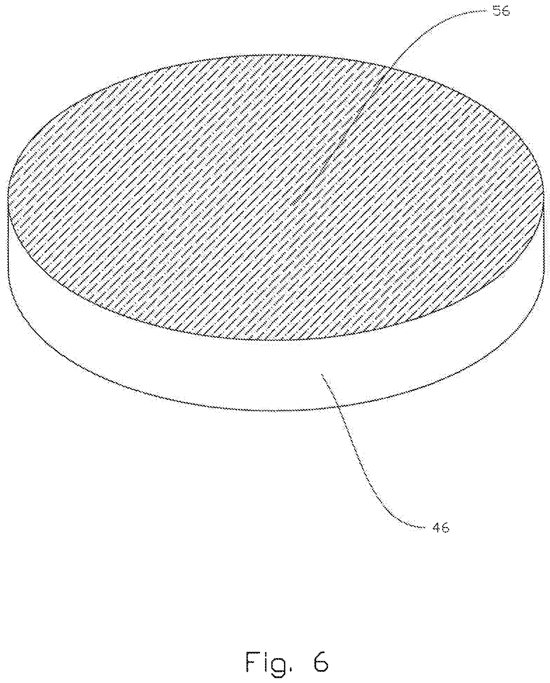

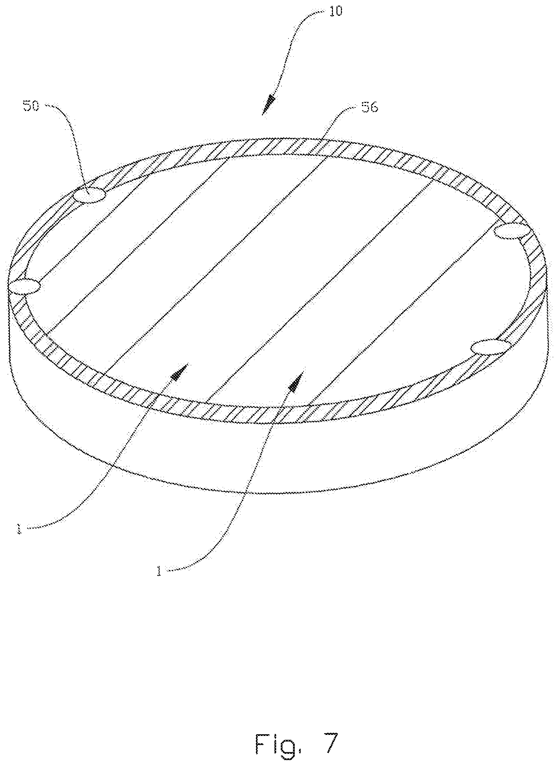

Figs. 4-7 show very schematically a method according to the third aspect of the invention, namely a method of assembling a system 10 according to the second aspect of the invention. A wall 46 is set up, here shown in a circular shape, after which a water tight membrane 48 is fit into the ground area 42 enclosed by the wall. The volume defined by the wall is then filled with water 56, and finally one or more modules 1 according to the first aspect of the invention are lifted into the water reservoir 44 to float therein. In the schematic embodiment shown in Fig. 7, several modules 1 are assembled so as to create a substantially circular form fitting complementary into the water reservoir 44.

It should be noted that the above-mentioned embodiments illustrate rather than limit the invention, and that those skilled in the art will be able to design many alternative embodiments without departing from the scope of the appended claims. In the claims, any reference signs placed between parentheses shall not be construed as limiting the claim. Use of the verb "comprise" and its conjugations does not exclude the presence of elements or steps other than those stated in a claim. The article "a" or "an" preceding an element does not exclude the presence of a plurality of such elements.

The mere fact that certain measures are recited in mutually different dependent claims does not indicate that a combination of these measures cannot be used to advantage.

## Claims

1. Floatable module (1) for concentrating incident solar radiation (12) onto photovoltaic elements (4), the module (1) comprising:
- a plurality of photovoltaic elements (4), provided as substantially parallel elongated strips, each having a surface (14) for receiving incident solar radiation (12);
- a plurality of linear reflectors (6) with primary, concave surfaces (8) for concentrating said incident solar radiation (12) onto said photovoltaic elements (4) substantially evenly onto said surfaces (14) for receiving incident solar radiation, said reflectors (6) having horizontal length axes (L) substantially parallel to said parallel elongated strips (4); and
- a substantially flat base (3) onto which said reflectors (6) and photovoltaic elements (4) are placed, whereby the PV elements (4) and the reflectors (6) are provided at equal height, **characterised in that**
- said photovoltaic elements (4) are placed non-horizontally on said base (3) such that a normal (N) of said surface (14) for receiving incident solar radiation (12) has an upwardly directed vertical component (V).

2. Module (1) according to any of the preceding claims, wherein said base (3) is substantially flat.

3. Module (1) according to claim 2, wherein said base (3) is provided with an upper surface (36) and a lower surface (38), and wherein said plurality of photovoltaic elements (4) are provided in contact with said upper surface (36) of the base (4).

4. Module (1) according to claim 3, wherein said base (3), between said upper and lower surfaces (36, 38), is provided with ducts (40) extending substantially parallel to said elongated strips (4) of photovoltaic elements.

5. Module (1) according to any of the preceding claims, wherein said plurality of reflectors (6) are comprises an outer portion (28) including an outer reflecting surface material and an inner portion comprising a stabilizing structure (30).

6. Module (1) according to any of the preceding claims, wherein said plurality of reflectors (6) further are formed with secondary, convex surfaces (22) for reflecting non-direct and diffuse solar radiation onto adjacent photovoltaic elements (4).

7. System (10) for concentrating incident solar radiation (12) onto photovoltaic elements (4), the system (10) comprising:
- a floatable module (1) according to any of the claims 1-6;
- a water reservoir (44) with a ground area (42) adapted to house said base (1); and
- a rotation means (50) for rotating said base (3) in said water reservoir (44) around a substantially vertical axis.

8. System (10) according to claim 7, wherein said rotation means (50) are included in said module (1).

9. System (10) according to claim 7 or 8, wherein said system (10) further comprises a tracking means (52) for controlling the rotation of the module (1) such that length axes (L) of said linear reflectors are oriented towards the horizon at a point substantially vertically below the position of the sun in the sky.

10. System (10) according to any of the claims 7-9, wherein the system (10) further comprises a pump (54) for circulating water from the bottom of said water reservoir (44) and up towards said floating module (1).

11. System (10) according to any of the claims 7-10, wherein the top of said module (1) is covered by glass, and wherein said module (1) is water-tightly encapsulated.

12. System (10) according to any of the claims 7-11, wherein the system (10) further includes means for hot water production.

13. System (10) according to claim 12, wherein channels for the production and transport of hot water are connected to the lower side of said encapsulated module.

14. Method for assembling a system (10) according to claim 7, the method comprising the steps of:
- providing a water reservoir (44) by putting up a wall (46), preferably substantially circular, defining a volume with a closed ground area (42);
- adding a water-tight membrane (48) onto said closed ground area (42);
- filling at least a portion of the volume defined by the wall (46) with water (56); and
- providing one or more modules (1) according to any of the claims 1-6 onto the water (56) in the water reservoir (44).

15. Method according to claim 14, wherein the method further includes producing power by means of the assembled system (10) by means of the following steps:
- tracking the sun's motion in the sky; and
- rotating said one or more modules such that the length axes of said reflectors are oriented towards the horizon at a point substantially vertically below the position of the sun in the sky.

## Patentansprüche

1. Schwimmfähiges Modul (1) zum Konzentrieren von einfallender Sonneneinstrahlung (12) auf Photovoltaikelemente (4), wobei das Modul (1) umfasst:
- eine Vielzahl von Photovoltaikelementen (4), welche als im Wesentlichen parallele längliche Streifen vorgesehen sind und jeweils eine Oberfläche (14) zur Aufnahme von einfallender Sonneneinstrahlung (12) aufweisen;
- eine Vielzahl von linearen Reflektoren (6) mit primären, konkaven Oberflächen (8) für die Konzentrierung der einfallenden Solarstrahlung (12) auf die Photovoltaikelemente (4) im Wesentlichen gleichmässig auf den Oberflächen (14) zur Aufnahme von einfallender Sonneneinstrahlung, wobei die Reflektoren (6) horizontale Längsachsen (L) aufweisen, die im Wesentlichen parallel zu den parallelen länglichen Streifen (4) sind; und
- eine im Wesentlichen flache Basis (3), auf welcher die Reflektoren (6) und Photovoltaikelemente (4) platziert sind, wodurch die PV Elemente (4) und die Reflektoren (6) auf gleicher Höhe vorgesehen sind, **dadurch gekennzeichnet, dass**
- die Photovoltaikelemente (4) nicht-horizontal auf der Basis (3) angeordnet sind, so dass eine Normale (N) der Oberfläche (14) zur Aufnahme von einfallender Sonneneinstrahlung (12) eine nach oben gerichtete vertikale Komponente (V) hat.

2. Modul (1) gemäss einem der vorhergehenden Ansprüche, wobei die Basis (3) im Wesentlichen flach ist.

3. Modul (1) gemäss Anspruch 2, wobei die Basis (3) mit einer oberen Oberfläche (36) und einer unteren Oberfläche (38) versehen ist, und wobei die Vielzahl von Photovoltaikelementen (4) in Kontakt mit der oberen Oberfläche (36) der Basis (4) vorgesehen sind.

4. Modul (1) gemäss Anspruch 3, wobei die Basis (3), zwischen der oberen und unteren Oberflächen (36, 38), mit Kanälen (40) versehen ist, welche sich im Wesentlichen parallel zu den länglichen Streifen (4) der Photovoltaikelemente erstrecken.

5. Modul (1) gemäss einem der vorhergehenden Ansprüche, wobei die Vielzahl der Reflektoren (6) einen äusseren Abschnitt (28) umfassend ein äusseres reflektierendes Oberflächenmaterial und einen inneren Abschnitt umfassend eine stabilisierende Struktur (30) umfasst.

6. Modul (1) gemäss einem der vorhergehenden Ansprüche, wobei die Vielzahl von Reflektoren (6) weiter mit sekundären konvexen Oberflächen (22) zur Reflexion von nichtdirekter und diffuser Sonneneinstrahlung auf benachbarte Photovoltaikelemente (4) ausgebildet sind.

7. System (10) zum Konzentrieren von einfallender Sonneneinstrahlung (12) auf Photovoltaikelemente (4), wobei das System (10) umfasst:
- ein schwimmfähiges Modul (1) gemäss einem der Ansprüche 1-6;
- ein Wasserreservoir (44) mit einer Bodenfläche (42), welches dazu eingerichtet ist, die Basis (1) aufzunehmen; und
- Rotationsmittel (50) zur Rotation der Basis (3) im Wasserreservoir (44) um eine im Wesentlichen vertikale Achse.

8. System (10) gemäss Anspruch 7, wobei die Rotationsmittel (50) im Modul (1) enthalten sind.

9. System (10) gemäss Anspruch 7 oder 8, wobei das System (10) weiter Nachführmittel (52) zur Steuerung der Rotation des Moduls (1) umfasst, so dass Längsachsen (L) der linearen Reflektoren in Richtung des Horizontes an eine Stelle, welche im Wesentlichen vertikal unterhalb der Position der Sonne im Himmel, gerichtet sind.

10. System (10) gemäss einem der Ansprüche 7-9, wobei das System (10) weiter eine Pumpe (54) zur Zirkulation von Wasser vom Boden des Wasserreservoirs (44) und nach oben in Richtung des schwimmenden Moduls (1) umfasst.

11. System (10) gemäss einem der Ansprüche 7-10, wobei die Oberseite des Moduls (1) mit Glass bedeckt ist, und wobei das Modul (1) wasserdicht eingekapselt ist.

12. System (10) gemäss einem der Ansprüche 7-11, wobei das System (10) weiter Mittel zur Heisswassererzeugung umfasst.

13. System (10) gemäss Anspruch 12, wobei Kanäle zur Erzeugung und zum Transport von heissem Wasser mit der unteren Seite des eingekapselten Moduls verbunden sind.

14. Verfahren zur Montage eines Systems (10) gemäss Anspruch 7, wobei das Verfahren die Schritte umfasst von:
- Vorsehen eines Wasserreservoirs (44) durch Aufstellen einer vorzugsweise im Wesentlichen kreisförmigen Wand (46), welche ein Volumen mit einer geschlossenen Bodenfläche (42) definiert;
- Hinzufügen einer wasserdichten Membran (48) auf die geschlossene Bodenfläche (42);
- Füllen mindestens eines Teiles des durch die Wand (46) definierten Volumens mit Wasser (56); und
- Vorsehen von einem oder mehreren Modulen (1) gemäss einem der Ansprüche 1 bis 6 auf dem Wasser (56) im Wasserreservoir (44).

15. Verfahren gemäss Anspruch 14, wobei das Verfahren weiter beinhaltet das Erzeugen von Strom mittels des montierten Systems (10) mittels der folgenden Schritte:
- Verfolgen der Sonnenbewegung am Himmel; und
- Rotieren des einen oder mehreren Module derart, dass die Längsachsen der Reflektoren in Richtung des Horizontes an eine Stelle, welche im Wesentlichen vertikal unterhalb der Position der Sonne im Himmel, gerichtet sind.

## Revendications

1. Un module flottant (1) destiné à concentrer le rayonnement solaire incident (12) sur des éléments photovoltaïques (4), le module (1) comprenant :
- une pluralité d'éléments photovoltaïques (4), disposés sous la forme de bandes allongées sensiblement parallèles, présentant chacune une surface (14) destinée à recevoir le rayonnement solaire incident (12) ;
- une pluralité de réflecteurs linéaires (6) présentant des surfaces concaves primaires (8) pour concentrer ledit rayonnement solaire incident (12) sur lesdits éléments photovoltaïques (4) de manière sensiblement uniforme sur lesdites surfaces (14) destinées à recevoir le rayonnement solaire incident (12), lesdits réflecteurs (6) ayant des axes longitudinaux horizontaux (L) sensiblement parallèles auxdites bandes allongées parallèles (4) ; et
- une base (3) sensiblement plane sur laquelle lesdits réflecteurs (6) et lesdits éléments photovoltaïques (4) sont placés, selon quoi les éléments photovoltaïques (4) et les réflecteurs (6) sont prévus à une même hauteur, **caractérisé en ce que**
- lesdits éléments photovoltaïques (4) sont placés non horizontalement sur ladite base (3) de manière qu'une normale (N) à ladite surface (14) destinée à recevoir le rayonnement solaire incident (12) possède une composante verticale (V) dirigée vers le haut.

2. Un module (1) selon l'une quelconque des revendications précédentes, dans lequel ladite base (3) est sensiblement plate.

3. Un module (1) selon la revendication 2, dans lequel ladite base (3) est munie d'une surface supérieure (36) et d'une surface inférieure (38), et dans lequel ladite pluralité d'éléments photovoltaïques (4) sont prévus en contact avec ladite surface supérieure (36) de la base (4).

4. Un module (1) selon la revendication 3, dans lequel ladite base (3), entre lesdites surfaces supérieures et inférieures (36, 38), est munie de conduites (40) sensiblement s'étendant parallèlement aux dites bandes allongées (4) des éléments photovoltaïques.

5. Un module (1) selon l'une quelconque des revendications précédentes, dans lequel ladite pluralité de réflecteurs (6) comprend une partie extérieure (28) incluant un matériau à surface réfléchissante extérieure et une partie intérieure comprenant une structure de support (30).

6. Un module (1) selon l'une quelconque des revendications précédentes, dans lequel ladite pluralité de réflecteurs (6) sont en outre formés avec des surfaces convexes secondaires (22) destinées à réfléchir le rayonnement solaire non-direct et diffus sur des éléments photovoltaïques (4) adjacents.

7. Un système (10) destiné à concentrer le rayonnement solaire incident (12) sur des éléments photovoltaïques (4), le système (10) comprenant:
- un module flottant (1) selon l'une quelconque des revendications 1 à 6;
- un réservoir d'eau (44) ayant une surface de base (42) adaptée pour abriter ladite base (1); et
- des moyens de rotation (50) pour tourner ladite base (3) dans ledit réservoir d'eau (44) autour d'un axe sensiblement vertical.

8. Un système (10) selon la revendication 7, dans lequel lesdits moyens de rotation (50) sont inclus dans ledit module (1).

9. Un système (10) selon la revendication 7 ou 8, dans lequel ledit système (10) comprend en outre des moyens de surveillance (52) pour contrôler la rotation du module (1) de sorte que les axes longitudinaux (L) desdits réflecteurs linéaires sont orientés vers l'horizon au niveau d'un point sensiblement verticalement au-dessous de la position du soleil dans le ciel.

10. Un système (10) selon l'une quelconque des revendications 7 à 9, dans lequel le système (10) comprend en outre une pompe (54) pour circuler l'eau depuis le fond dudit réservoir d'eau (44) vers le haut en direction du module flottant (1).

11. Un système (10) selon l'une quelconque des revendications 7 à 10, dans lequel le sommet dudit module (1) est recouvert par du verre, est dans lequel ledit module (1) est encapsulé de manière étanche à l'eau.

12. Un système (10) selon l'une quelconque des revendications 7 à 11, dans lequel le système (10) comprend en outre un moyen pour la production d'eau chaude.

13. Un système (10) selon la revendication 12, dans lequel des canaux pour la production et l'acheminement d'eau chaude sont reliés au côté inférieur dudit module encapsulé.

14. Un procédé pour assembler un système (10) selon la revendication 7, le procédé comprenant les étapes de:
- mettre à disposition un réservoir d'eau (44) en érigant une paroi (46), préférablement sensiblement circulaire, définissant a volume ayant une surface de base fermée (42);
- ajouter une membrane étanche à l'eau (48) sur ladite surface de base fermée (42);
- remplir au moins une partie du volume défini par la paroi (46) avec de l'eau (56); et
- fournir un ou plusieurs modules (1) selon l'une quelconque des revendications 1 à 6 sur l'eau (56) dans le réservoir d'eau (44).

15. Un procédé selon la revendication 14, dans lequel le procédé inclut en outre produire de l'énergie électrique au moyen du système assemblé (10) au moyen d'une des étapes suivantes:
- suivre le mouvement du soleil dans le ciel; et
- tourner ledit un ou plusieurs modules de sorte que les axes longitudinaux desdits réflecteurs sont orientés vers l'horizon au niveau d'un point sensiblement verticalement en dessous de la position du soleil dans le ciel.
